(19)

Europäisches
Patentamt
European
Patent Office
Office européen
des brevets

(11) **EP 1 965 259 A2**

(12) # EUROPEAN PATENT APPLICATION

(43) Date of publication:
**03.09.2008 Bulletin 2008/36**

(51) Int Cl.:
**G03F 7/20** (2006.01)

(21) Application number: **08152054.6**

(22) Date of filing: **28.02.2008**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **01.03.2007 JP 2007051934**

(71) Applicant: **Canon Kabushiki Kaisha
Ohta-Ku,
Tokyo 146-8501 (JP)**

(72) Inventors:
• **Tokurakawa, Masaki
Tokyo 146-8501 (JP)**
• **Takahashi, Kazuhiro
Tokyo 146-8501 (JP)**

(74) Representative: **TBK-Patent
Bavariaring 4-6
80336 München (DE)**

(54) **Measurement apparatus, exposure apparatus, and device fabrication method**

(57)    The present invention provides a measurement apparatus that includes a measurement unit inserted on an image plane of an optical system to be measured, and a measurement mask inserted on an object plane of the optical system to be measured, said measurement unit including a light-shielding board including a slit-like image-side opening part, and said measurement mask including a rectangular light-shielding part being configured to form a projection image having a longitudinal dimension and lateral dimension longer than a longitudinal dimension and lateral dimension of said image-side opening part on the image plane of the optical system to be measured, and object-side opening parts formed on two sides of said light-shielding part, wherein said measurement apparatus measures flare generated by the optical system to be measured by measuring a light quantity by said light quantity sensor while the projection image covers said image-side opening part.

# FIG. 7

EP 1 965 259 A2

**Description**

BACKGROUND OF THE INVENTION

Field of the Invention

The present invention relates to a measurement apparatus, an exposure apparatus, and a device fabrication method.

Description of the Related Art

A projection exposure apparatus has conventionally been employed to fabricate a semiconductor device using photolithography. The projection exposure apparatus projects and transfers a circuit pattern formed on a reticle (mask) onto, e.g., a wafer via a projection optical system. Along with the recent micropatterning of a semiconductor device, a demand for the line width uniformity of a pattern transferred onto a wafer is becoming stricter. For this reason, deterioration in line width uniformity due to flare which is generated by a projection optical system but could be neglected conventionally is becoming problematic. The flare here means stray light (e.g., light which reaches a wafer after multiple reflection at various positions) which adversely affects the imaging of a reticle pattern.

Flare generated by an optical system can be roughly classified into long-range flare and local flare (middle-range flare). Local flare is conspicuously problematic from the viewpoint of deterioration in line width uniformity nowadays, and it will be explained below.

Local flare is high-frequency components due to small shape errors of the surface of a lens (optical member) or the refractive index nonuniformity of a lens material. The amount of local flare generation is proportional to the square of the reciprocal of the wavelength of incident light. The shorter the exposure light wavelength, the greater the influence of local flare on the line width uniformity. A recent exposure apparatus adopts an ArF excimer laser (wavelength: about 193 nm) as the exposure light, and fluorite ($CaF_2$) as a lens material compatible with such short-wavelength exposure light. However, fluorite generates birefringence more readily than synthetic quartz ($SiO_2$), and also generates large quantities of high-frequency components than those due to the surface roughness and refractive index nonuniformity. The amount of local flare generation tends to increase owing to the shortening of the exposure light wavelength and the property of fluorite (lens material) described above. This makes it necessary to quantitatively determine the influence of such local flare on the pattern line width (i.e., accurately measure local flare).

To quantitatively determine the influence of local flare on the pattern line width, the local flare is measured using, as a parameter, the distance between an incident light position at which local flare is generated and a pattern position influenced by it. Under the circumstances, there is proposed a technique of transferring a measurement pattern in which a plurality of types of circular opening parts are formed around a line pattern onto a resist by exposure, and quantitatively measuring local flare based on the relationship between the line width of the line pattern and the sizes of the opening parts. See Japanese Patent Laid-Open No. 2004-64024 (to be referred to as "reference 1" hereinafter) for details of this technique.

There is also proposed a technique of transferring a measurement pattern having a light-shielding part called a pad pattern onto a resist by overexposure, and quantitatively measuring local flare which enters the pad pattern based on the exposure quantity until a resist portion corresponding to the pad pattern disappears. See "0.85NA ArF Exposure System and Performance, Proc. SPIE, Vol. 5040, pp. 789 - 800, 2003" (to be referred to as "reference 2" hereinafter) for details of this technique.

There is also proposed a technique of transferring a measurement pattern in which a line pattern is formed and a light-transmitting part is formed around it onto a resist by exposure instead of using a pad pattern, and quantitatively measuring local flare based on a change in the line width of the line pattern formed by exposure. See Japanese Patent Laid-Open No. 2004-296648 (to be referred to as "reference 3" hereinafter) for details of this technique.

There is also proposed a technique of measuring the light quantity at a position corresponding to a pad pattern using a light quantity sensor instead of exposing a resist, and quantitatively measuring local flare which enters the pad pattern.

See Japanese Patent Laid-Open No. 2006-80245 (to be referred to as "reference 4" hereinafter) for details of this technique.

Unfortunately, none of the prior arts can accurately measure local flare in a short period of time. Assume, for example, that a pad pattern (measurement pattern) is transferred onto a resist by exposure and local flare is measured as in the technique disclosed in reference 2. In this case, it takes much time to obtain a measurement result because several processes must be performed. Still worse, the measurement result is influenced by the resist process, and a state in which a resist portion corresponding to the pad pattern has disappeared completely can hardly be determined. This makes it difficult to accurately measure local flare. In an optical system which generates local flare in relatively small amounts, an exposure quantity necessary to make the resist portion corresponding to the pad pattern disappear may increase to the degree that the linearity of the resist sensitivity degrades.

Assume that local flare is measured based on a change in the line width of a line pattern formed by exposure as in the technique disclosed in reference 3. In this case, as local flare reduces, a change in the line width of the line pattern formed by exposure also reduces proportionally. The line width of the resist pattern changes not only due to the presence of local flare but also due to various errors such as an error associated with the line width measurement accuracy and focus errors attributed to a process and apparatus. Therefore, there is a limit to extracting only a very small change in the line width of the line pattern formed by exposure due to the presence of local flare from changes in line width due to various factors, and accurately measuring the local flare.

Assume that local flare is measured using a light quantity sensor as in the technique disclosed in reference 4. Even in this case, local flare cannot be accurately measured depending on the size and shape of an opening part formed immediately above the light quantity sensor. In other words, it is impossible to accurately measure local flare even by directly using a pad pattern used in exposing a resist to measure the light quantity at a position, at which a projection image of the pad pattern is formed, by the light quantity sensor. It is indispensable to form an opening part immediately above the light quantity sensor to be smaller than a projection image of the pad pattern. To measure local flare using the distance as a parameter, if, for example, the size of a projection image of the pad pattern is about 2 $\mu$m, the size of an opening part formed immediately above the light quantity sensor must be 1 $\mu$m or less. However, the quantity of light passing through an opening part having a size of about 1 $\mu$m is insufficient to obtain a satisfactory signal (S/N ratio) because of, e.g., the influence of noise. This makes it impossible to accurately measure local flare.

To improve the measurement accuracy by ensuring a sufficient light quantity, the size of an opening part formed immediately above the light quantity sensor may be increased. However, merely increasing the size of the opening part is insufficient to measure local flare generated at a position as close as about 1 $\mu$m because the size of the pad pattern must be increased in accordance with that of the opening part.

SUMMARY OF THE INVENTION

The present invention provides a measurement apparatus which can accurately measure local flare, which is generated by an optical system to be measured, in a short period of time.

The present invention in its first aspect provides a measurement apparatus as specified in claims 1 to 6.

The present invention in its second aspect provides an exposure apparatus as specified in claim 7.

The present invention in its third aspect provides a device fabrication method as specified in claim 8.

Further features of the present invention will become apparent from the following description of exemplary embodiments with reference to the attached drawings.

BRIEF DESCRIPTION OF THE DRAWINGS

Fig. 1 is a schematic sectional view showing a measurement apparatus according to one aspect of the present invention.

Fig. 2 is a schematic top view showing a measurement mask of the measurement apparatus shown in Fig. 1.

Fig. 3 is a schematic enlarged view showing a measurement pattern of the measurement mask shown in Fig. 2.

Fig. 4 is a schematic top view showing a measurement unit of the measurement apparatus shown in Fig. 1.

Fig. 5 is a schematic top view showing a conventional measurement pattern to measure local flare.

Fig. 6 is a view showing a state in which the conventional measurement pattern shown in Fig. 5 and a light-shielding board having an opening part with an area increased in accordance with a pad pattern in the measurement pattern are superimposed on each other.

Fig. 7 is a view showing a state in which the measurement pattern shown in Fig. 3 and the measurement unit (light-shielding board) shown in Fig. 4 are superimposed on each other.

Fig. 8 is a view for explaining the meaning of a measurement value Iab given by equation (4).

Fig. 9 is a graph showing the light intensity distribution (cross-section) of a projection image of the measurement pattern shown in Fig. 3.

Fig. 10 is a schematic top view showing a measurement mask applicable to the measurement apparatus shown in Fig. 1.

Fig. 11 is a schematic top view showing a measurement unit applicable to the measurement apparatus shown in Fig. 1.

Fig. 12 is a schematic top view showing a measurement mask applicable to the measurement apparatus shown in Fig. 1.

Figs. 13A to 13C are schematic top views showing a plurality of measurement masks applicable to the measurement apparatus shown in Fig. 1.

Fig. 14 is a schematic top view showing a measurement mask applicable to the measurement apparatus shown in Fig. 1.

Fig. 15 is a schematic top view showing a measurement unit applicable to the measurement apparatus shown in Fig. 1.

Fig. 16 is a schematic sectional view showing an exposure apparatus according to one aspect of the present invention.

Fig. 17 is a flowchart for explaining a method for fabricating devices.

Fig. 18 is a detail flowchart of a wafer process in Step 4 of Fig. 17.

DESCRIPTION OF THE EMBODIMENT

A preferred embodiment of the present invention will be described below with reference to the accompanying drawings. The same reference numerals denote the same members throughout the drawings, and a repetitive description thereof will be omitted.

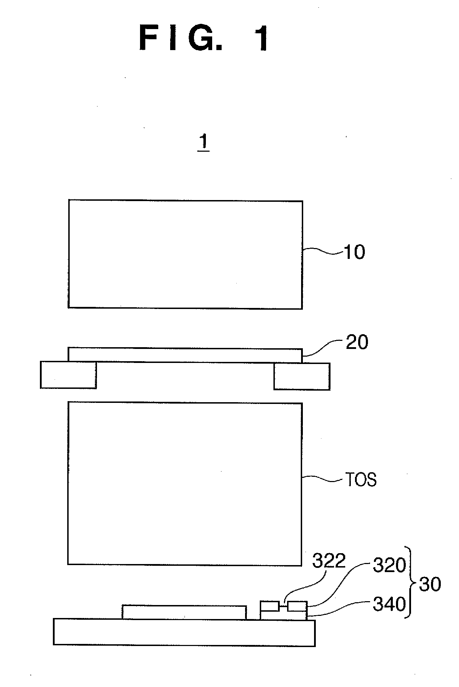

Fig. 1 is a schematic sectional view showing a measurement apparatus 1 according to one aspect of the present invention. The measurement apparatus 1 measures flare generated by an optical system TOS to be measured. In this embodiment, the optical system TOS to be measured is a projection optical system used for an exposure apparatus, and the measurement apparatus 1 measures local flare generated by the projection optical system. The local flare has a small convergence angle and is distributed near (within the range of 1 $\mu$m to several tens of micrometers of) the poles of incident light. As shown in Fig. 1, the measurement apparatus 1 includes an illumination apparatus 10, measurement mask 20, and measurement unit 30.

The illumination apparatus 10 illuminates the measurement mask 20 using, e.g., a KrF excimer laser (wavelength: about 248 nm), ArF excimer laser (wavelength: about 193 nm), $F_2$ laser (wavelength: about 157 nm), or mercury lamp (i-line) as a light source.

The measurement mask 20 is inserted on the object plane of the optical system TOS to be measured. As will be described later, the measurement mask 20 has a measurement pattern including a light-shielding part (light-shielding region) for shielding the light from the illumination apparatus 10 and an object-side opening part (light-transmitting region) for transmitting the light from the illumination apparatus 10.

The measurement unit 30 is inserted on the image plane of the optical system TOS to be measured. The measurement unit 30 has a light-shielding board 320 having a slit-like opening part (image-side opening part) 322, and a light quantity sensor 340 for measuring the quantity of light passing through the opening part 322. As will be described later, the measurement unit 30 measures the quantity of light passing through the opening part 322 while a projection image of the light-shielding part of the measurement mask 20 covers the opening part 322 of the light-shielding board 320.

As will be described later, the measurement apparatus 1 measures the light quantity (the light quantity on a projection image of the measurement pattern of the measurement mask 20, which is projected onto the opening part 322) in a range defined by the slit-like opening part 322, using the measurement unit 30. This makes it possible to accurately measure local flare, which is generated by the optical system TOS to be measured, in a short period of time without any resist exposure process and development process.

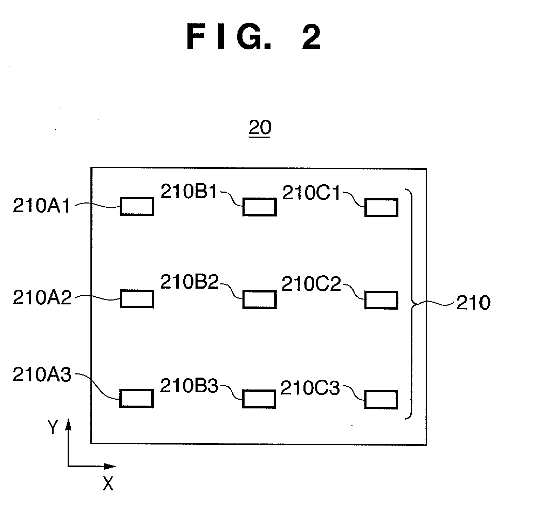

The measurement mask 20 and measurement unit 30 will be explained in detail below. The measurement mask 20 will be explained first. Fig. 2 is a schematic top view showing the measurement mask 20. In this embodiment, as shown in Fig. 2, the measurement mask 20 has a plurality of measurement patterns 210 (measurement patterns 210A1 to 210A3, 210B1 to 210B3, and 210C1 to 210C3). Although the measurement mask 20 has 3 (X direction) x 3 (Y direction), i.e., nine measurement patterns 210 in this embodiment, it need not necessarily have nine measurement patterns 210.

For example, when the measurement mask 20 is scanned in the Y direction, only one measurement pattern 210 need be formed in the Y direction. However, to measure local flare at a plurality of image heights of the optical system TOS to be measured, a plurality of measurement patterns 210 are preferably formed in the X direction in correspondence with the measurement points of the local flare.

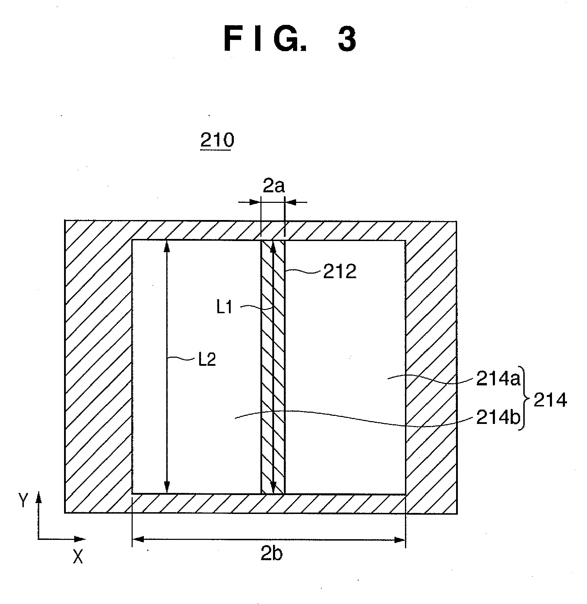

Fig. 3 is a schematic enlarged view showing the measurement pattern 210 of the measurement mask 20. As shown in Fig. 3, the measurement pattern 210 has a rectangular light-shielding part 212, and an opening part (object-side opening part) 214 (including opening parts 214a and 214b) formed on the two sides of the light-shielding part 212.

The light-shielding part 212 forms a projection image having longitudinal and lateral dimensions longer than those of the opening part 322 of the light-shielding board 320 on the image plane of the optical system TOS to be measured. To ensure a sufficient quantity of light passing through the measurement mask 20, a dimension L1 of the light-shielding part 212 in a direction (second direction) perpendicular to its widthwise direction (first direction) is set sufficiently longer than a dimension 2a of the light-shielding part 212 in its widthwise direction. More specifically, the dimension L1 of the light-shielding part 212 in a direction perpendicular to its widthwise direction is preferably 10 times or more of the dimension 2a of the light-shielding part 212 in its widthwise direction.

The opening part 214 has a dimension 2b in its widthwise direction, and a dimension L2, in a direction perpendicular to its widthwise direction, nearly equal to the dimension L1 of the light-shielding part 212. The light-shielding part 212 separates the opening part 214 into two opening parts 214a and 214b.

A projection image of the measurement pattern 210 (light-shielding part 212) projected onto the image plane of the optical system TOS to be measured has a size which satisfies 2a' = 2βa and L1' = βL1, wherein β is the reduction magnification of the optical system TOS to be measured, 2a' is the dimension of the projection image in its widthwise direction, and L1' is the dimension of the projection image in a direction perpendicular to its widthwise direction.

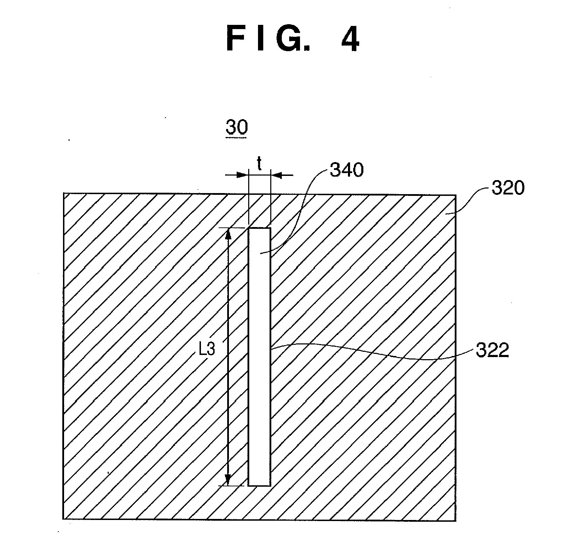

The measurement unit 30 will be explained next. Fig. 4 is a schematic top view showing the measurement unit 30. Fig. 4 shows the opening part 322 of the light-shielding board 320 of the measurement unit 30. A dimension t of the opening part 322 of the light-shielding board 320 in its widthwise direction is shorter than the dimension 2a' of the projection image of the measurement pattern 210 (light-shielding part 212) in its widthwise direction by, e.g., about 1 μm. A dimension L3 of the opening part 322 in a direction perpendicular to its widthwise direction is sufficiently longer than the dimension 2a' of the projection image of the measurement pattern 210 (light-shielding part 212) in its widthwise direction. For example, the dimension L3 is preferably 10 times or more of the dimension 2a'. The dimension L3 of the opening part 322 in a direction perpendicular to its widthwise direction is nearly equal to the dimension L1' of the projection image of the measurement pattern 210 (light-shielding part 212) in its widthwise direction or shorter than the dimension L1'.

Local flare generated by the optical system TOS to be measured will be explained. Let $G(X, Y)$ be a function describing the ratio of local flare at a coordinate position $(X, Y)$ to light (incident light) applied at a coordinate position $(0, 0)$. In other words, the function $G(X, Y)$ describes local flare at the coordinate position $(X, Y)$, which is generated by light applied at the coordinate position $(0, 0)$. Let $T(x', y')$ be a function describing an ideal intensity distribution of light applied at a coordinate position $(x', y')$. Then, an intensity ratio $I(x, y)$ of local flare measured at a point $(x, y)$ on the image plane of the optical system TOS to be measured is given by:

$$I(x, y) = \iint T(x', y') * G(x'-x, y'-y)dx'dy' \qquad \ldots (1)$$

which is the integrated quantity of local flare generated at an arbitrary point $(x', y')$ on the opening part.

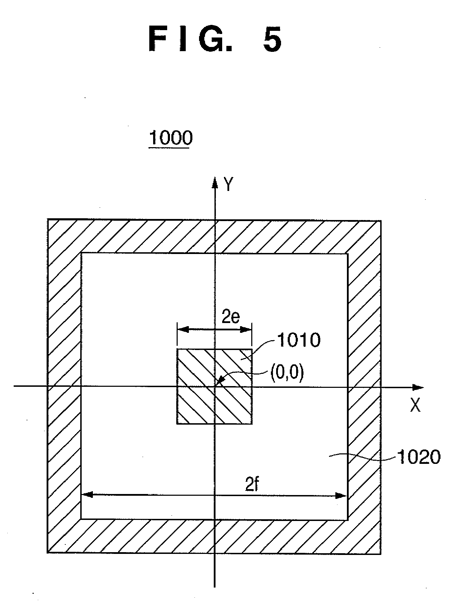

Fig. 5 is a schematic top view showing a conventional measurement pattern 1000 to measure local flare. The measurement pattern 1000 is formed on the object plane of the optical system TOS to be measured, and has a pad pattern 1010 serving as a light-shielding part and a window 1020 serving as an opening part. Assume that the central coordinate position of the pad pattern 1010 is $(0, 0)$, the pad pattern 1010 is a square having a side length 2e, and the window 1020 is a square having a side length 2f. Then, local flare Ief$(0, 0)$ at the central coordinate position $(0, 0)$ is given by:

$$Ief(0, 0) = \iint T(x, y) * G(x, y)dxdy \qquad \ldots (2)$$

Note that $T(x, y) = 1$ for $e < |x| < f$ and $e < |y|$ f, and $T(x, y) = 0$ for other x and y ranges.

Referring to equation (2), the local flare Ief$(0, 0)$ is defined by a length e half the side of the pad pattern 1010 and a length f half the side of the window 1020. In other words, the local flare Ief$(0, 0)$ is the sum total of local flare within the range of e μm to f μm with respect to incident light.

When a light quantity sensor is inserted at the central coordinate position $(0, 0)$ of the pad pattern 1010 in the conventional measurement pattern 1000 shown in Fig. 5 to measure the light quantity at this position, it is possible to measure local flare in principle. However, to measure the light quantity at the central coordinate position $(0, 0)$ of the pad pattern 1010, it is necessary to reduce the area of an opening part of the light-shielding board, which is formed immediately above the light quantity sensor. As a consequence, the quantity of light which enters the light quantity sensor decreases, so a sufficiently high S/N ratio cannot be obtained due to the influence of electrical noise. This makes it impossible to accurately measure local flare.

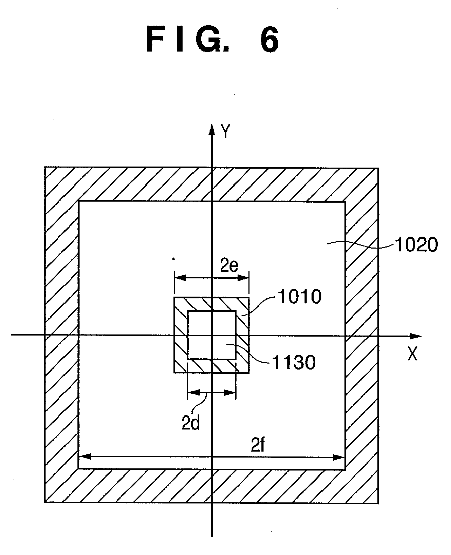

To solve this problem, the area of an opening part of the light-shielding board, which is formed immediately above the light quantity sensor, may be increased. However, as shown in Fig. 6, when the area of an opening part 1130 of the light-shielding board, which is formed immediately above a light quantity sensor, is isotropically increased, a light quantity necessary to measure local flare can be ensured but the range of the generated local flare cannot be defined. Fig. 6 is a view showing a state in which the conventional measurement pattern 1000 and the light-shielding board having an opening part 1130 with an area increased in accordance with the pad pattern 1010 in the measurement pattern 1000 are superimposed on each other.

As the size of the opening part 1130 becomes larger than a desirable local flare measurement range, e.g., from 1 μm to 2 μm, the range of local flare which enters the light quantity sensor changes depending on the position of the opening part 1130. When the opening part 1130 is assumed to be a square having a side length 2d (d < e « f and d » 1), the central portion of the light quantity sensor receives only local flare separated from incident light by e $\mu$m or more. This makes it impossible to precisely measure local flare within 1 $\mu$m to 2 $\mu$m from the incident light.

If, for example, e - d = 2 $\mu$m, local flare generated at a position 2 $\mu$m from the incident light enters the peripheral portion of the opening part 1130 but local flare separated from the incident light in all directions by the same distance cannot be measured two-dimensionally. In this manner, merely increasing the area of the opening part 1130 is insufficient to precisely measure local flare. In other words, to accurately measure local flare, it is necessary to optimize the shapes of the measurement pattern and the opening part of the light-shielding board.

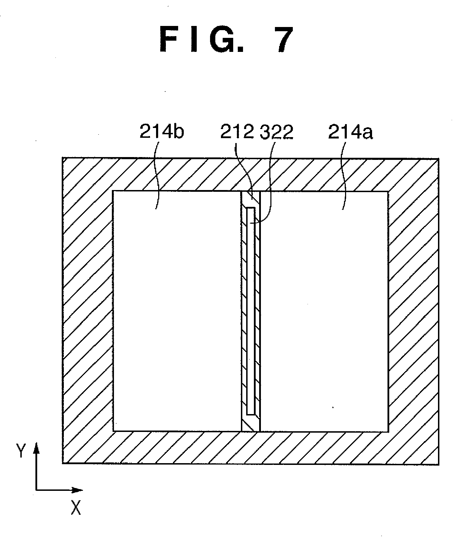

For this purpose, in this embodiment, a light-shielding board 320 has a slit-like opening part 322 and a measurement mask 20 has a rectangular light-shielding part 212 of a measurement pattern 210, which has longitudinal and lateral dimensions longer than those of the opening part 322, as shown in Fig. 7. With this arrangement, the area of an opening part is increased so as to ensure a sufficient quantity of light which enters the light quantity sensor and acquire the value of local flare as positional information. This makes it possible to specify the local flare distribution range. It is therefore possible to accurately measure the local flare distribution with respect to the position.

Referring to Fig. 7, a measurement value Iab obtained by measuring local flare using the measurement unit 30 is given by:

$$\mathrm{Iab} = (\iint (\iint \mathrm{T(x', y')} * \mathrm{G(x'-x, y'-y)dx'dy')dxdy)/(t*L3)} \quad ...(3)$$

Note that T(x', y') = 1 for a < |x'| < b and |y'| < L1/2, and T(x', y') = 0 for other x' and y' ranges.

Since integration is performed with respect to dx and dy in the range of the slit-like opening part 322 of the light-shielding board 320, |x| < t/2 and |y| < L3/2 assuming that its center is the origin.

The relationship between the measurement pattern 210 (light-shielding part 212) and the light-shielding board 320 (opening part 322) is determined such that G(b) → 0 if the dimension t of the opening part 322 in its widthwise direction becomes shorter than the minimum distance between measured local flare (e.g., 1 $\mu$m or less) and incident light and y > b. Local flare tends to reduce with increasing distance from incident light. Assuming that local flare is negligible when it is sufficiently separated from incident light by, e.g., a distance of 50 $\mu$m to 100 $\mu$m, equation (3) can be approximated by:

$$\mathrm{Iab} = \int (\iint \mathrm{T(x', y')} * \mathrm{G(x', y'- y)dx'dy')dy / L3}$$
$$\cong \iint \mathrm{T(x', y')} * \mathrm{G(x', y')dx'dy'} \quad ...(4)$$

The coordinate (y'-y) of the function G(x', y'-y) is zero for |y' - y| > b. For L1 > L3 + 2b, the integration of $\iint$ T(x',y')*G(x',y'-y)dx'dy' with respect to dy amounts to simply multiplying it by L3 so that equation (4) is obtained because L3 of the numerator is canceled by that of the denominator.

In this manner, a measurement value Iab obtained by measuring local flare using the measurement unit 30 is approximated by the local flare Ief (equation (2)) obtained at the central coordinate position (0, 0) of the pad pattern 1010 in the conventional measurement pattern 1000 shown in Fig. 5.

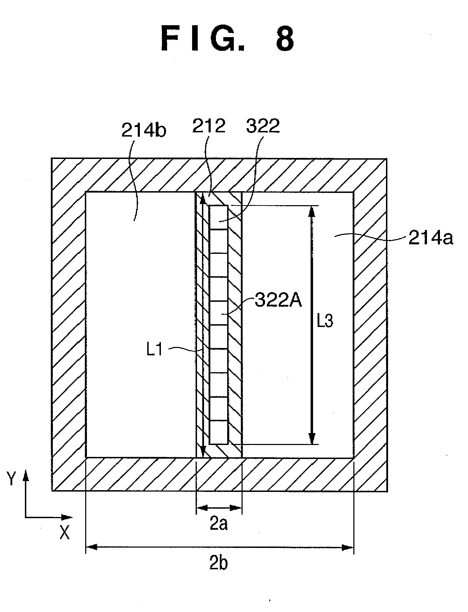

The measurement value Iab given by equation (4) is of local flare within the range of a $\mu$m to b $\mu$m. As shown in Fig. 8, consider a case in which a slit-like opening part 322 of a light-shielding board 320 is divided into a plurality of minute regions 322A in the Y direction. The minute regions 322A correspond to the pad pattern 1010 in the conventional measurement pattern 1000 shown in Fig. 5. In this embodiment, the minute regions 322A are accumulated in the Y direction to ensure a sufficient light quantity, thereby improving the measurement accuracy. A light-shielding part 212 of a measurement pattern 210 in this embodiment has a slit shape extending in the Y direction, unlike the pad pattern 1010 in the conventional measurement pattern 1000 shown in Fig. 5. The light-shielding part 212 in this embodiment allows acquiring the difference in local flare between two patterns as an offset in advance and correcting a measurement value Iab obtained by measuring local flare using the measurement unit 30. More specifically, local flare I1 is measured using the measurement pattern 1000 (note that the pad pattern 1010 has a side length 2a and the window 1020 has a side length 2b) shown in Fig. 5. Next, local flare I2 is measured using the measurement pattern 210 (that is, a measurement pattern having a light-shielding part obtained by increasing the area of the pad pattern 1010 in the Y direction) shown in Fig. 3. Lastly, the measurement value Iab obtained by measuring local flare using the measurement unit 30 is multiplied by a ratio I1/I2. Note that Fig. 8 is a view for explaining the meaning of the measurement value Iab given by equation (4).

This embodiment has exemplified a case in which the dimension L1 of the light-shielding part 212 of the measurement pattern 210 in a direction perpendicular to its widthwise direction and the dimension L3 of the opening part 322 of the light-shielding board 320 in a direction perpendicular to its widthwise direction satisfy L1 > L3 + 2b. However, if the dimension L3 of the opening part 322 of the light-shielding board 320 in a direction perpendicular to its widthwise direction is sufficiently longer than the dimension t of the opening part 322 in its widthwise direction, the dimensions L1 and L3 need not always satisfy the above-described relationship. If L1 = L3 or L1 > L3, it is possible to obtain the same effect as described above because a shift from the above-described relationship has little influence on the measurement accuracy.

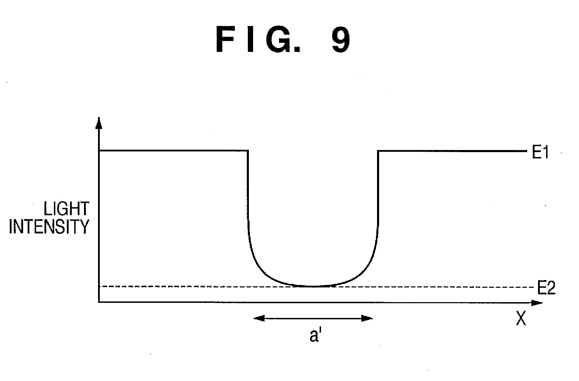

Fig. 9 is a graph showing the light intensity distribution (cross-section) of a projection image of the measurement pattern 210, which is formed on the image plane of the optical system TOS to be measured. The light intensity distribution as shown in Fig. 9 is obtained by measuring the light quantity on the projection image of the measurement pattern 210 using the light quantity sensor 340 while moving the slit-like opening part 322 of the light-shielding board 320 relative to this image in the widthwise direction of the opening part 322. Let E1 be the light quantity in a region in which the light-shielding part 212 of the measurement pattern 210 shields the slit-like opening part 322 of the light-shielding board 320. The light quantity E1 corresponds to the intensity of local flare corresponding to the measurement pattern 210.

Let E2 be the light quantity in a region in which the light-shielding part 212 of the measurement pattern 210 does not shield the slit-like opening part 322 of the light-shielding board 320. Then, the local flare ratio can be given by E1/E2 $\times$ 100 [%]. Note that the light quantity E1 cannot be correctly measured unless the direction of the measurement pattern 210 (light-shielding part 212) accurately matches the direction of the slit-like opening part 322 of the light-shielding board 320. For example, the light quantity E1 takes a measurement value larger than the actual value if the light-shielding part 212 of the measurement pattern 210 shifts from the opening part 322 of the light-shielding board 320 in the longitudinal direction of the opening part 322. In this case, the light quantity E1 is measured while moving the measurement pattern 210 (light-shielding part 212) or light-shielding board 320 (opening part 322), and its minimum value is adopted.

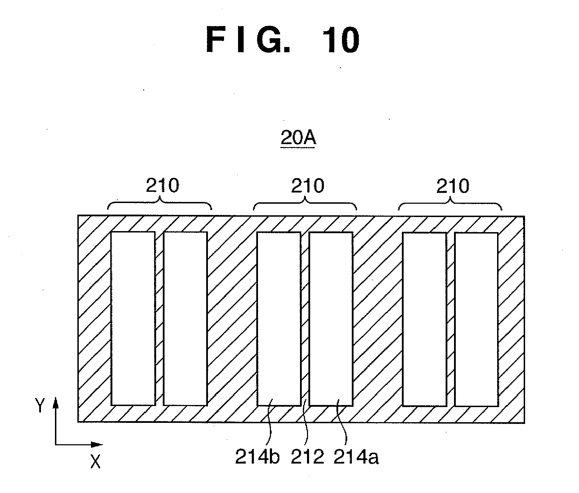

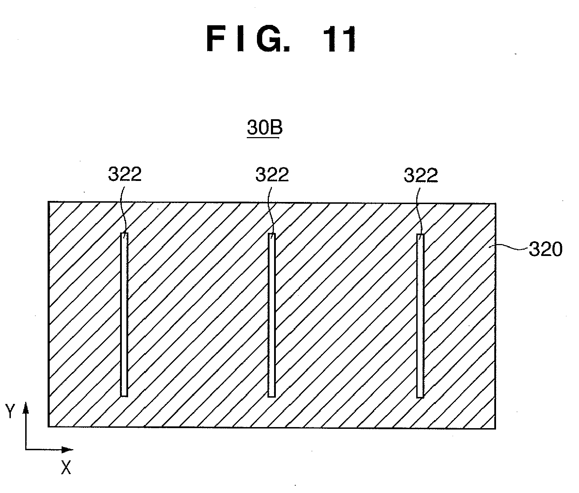

If a sufficient light quantity cannot be obtained when the opening part 322 of the light-shielding board 320 has only one slit, a measurement mask 20A having a plurality of measurement pattern 210 as shown in Fig. 10, and a measurement unit 30B having a light-shielding board 320 which includes a plurality of slit-like opening parts 322 as shown in Fig. 11 are used. This makes it possible to increase the quantity of light received by the light quantity sensor 340. As described above, at a position at which local flare is sufficiently separated from incident light by, e.g., 50 μm to 100 μm or more, the local flare is negligible. For this reason, influences other than those of opening parts adjacent to the slit-like opening parts 322 of the light-shielding board 320 may be neglected. Note that Fig. 10 is a schematic top view showing the measurement mask 20A. Fig. 11 is a schematic top view showing the measurement unit 30B.

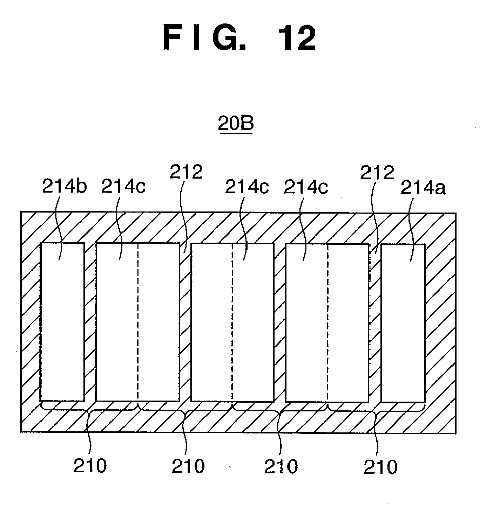

A measurement mask 20B as shown in Fig. 12 may be used. The measurement mask 20B has alternately formed opening parts 214c and light-shielding parts 212. The opening part 214c is formed by connecting opening parts 214a and 214b of adjacent measurement patterns 210. This makes it possible to reduce a region in which a plurality of measurement patterns 210 are formed. Note that Fig. 12 is a schematic top view showing the measurement mask 20B.

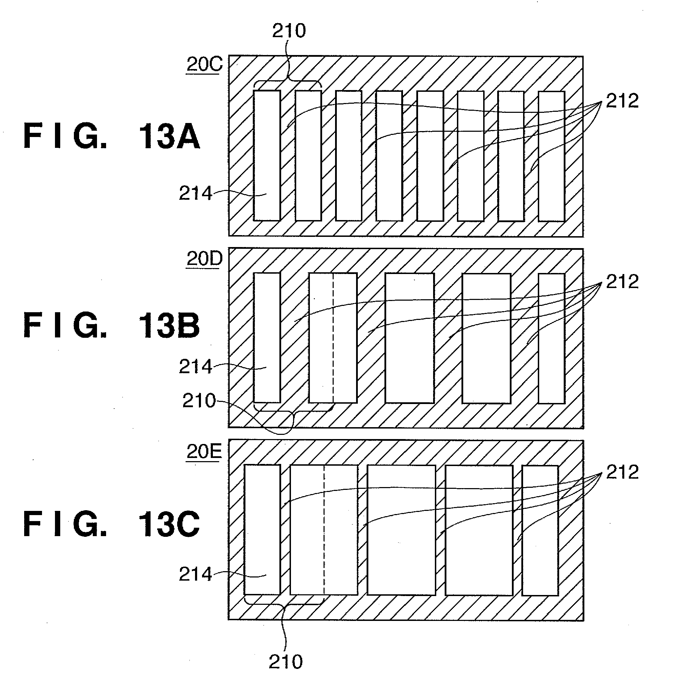

As shown in Figs. 13A to 13C, a plurality of measurement masks 20C to 20E including measurement patterns 210 having light-shielding parts 212 and opening parts 214 with different widths regard to each mask may be used. This makes it possible to selectively measure the spatial distribution range of local flare corresponding to the size of the measurement pattern 210. The measurement value of local flare corresponding to a given measurement pattern is of local flare Iab within the range of a μm to b μm, which is determined by a dimension 2a of the light-shielding part 212 of the measurement pattern 210 in its widthwise direction and a dimension 2b of the opening part 214 in its widthwise direction. When a plurality of local flares Iab are measured using the dimensions a and b as parameters, since Iab is an integrated value of a function G(x, y) describing the local flare distribution, a measurement value (integrated value) I of local flare can be approximated using a and b as a function of distance which defines the local flare distribution range. If the spatial distribution of local flare is isotropic, a distribution function G(r) can also be calculated by differentiating the measurement value I. Note that Figs. 13A to 13C are schematic top views showing the measurement masks 20C to 20E.

The above-described offset correction using the difference between measurement patterns is performed for a combination of the measurement patterns 210 having the light-shielding parts 212 and opening parts 214 with different widths shown in Figs. 13A to 13C. This allows correction for each local flare on the measurement patterns 210 having the light-shielding parts 212 and opening parts 214 with different widths. In addition, a mask having plural light-shielding parts 212 whose widths are different from each other and plural opening parts 214 whose widths are different from each other may be used to combine the above plural masks.

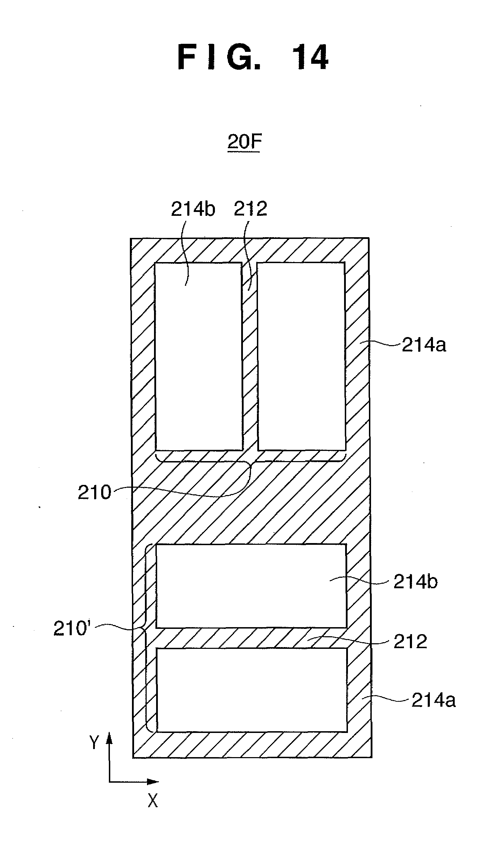

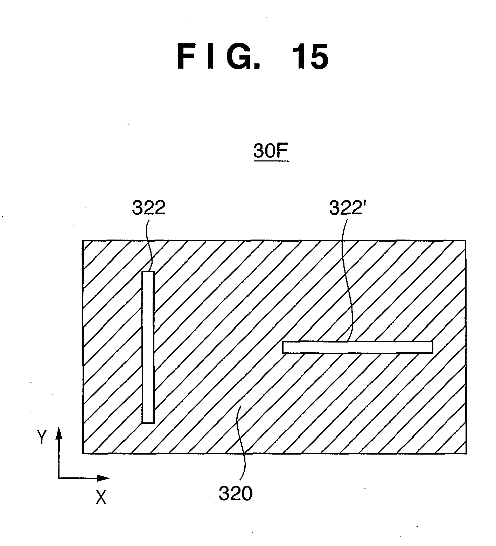

This embodiment has exemplified a case in which the longitudinal direction of the slit-like opening part 322 of the light-shielding board 320 is the Y direction. However, a measurement mask 20F including a measurement pattern 210' formed by rotating a measurement pattern 210 as shown in Fig. 14 through 90°, and a measurement unit 30F including an opening part 322' formed by rotating a slit-like opening part 322 as shown in Fig. 15 through 90° may be used. The measurement mask 20F has the measurement pattern 210 including a light-shielding part 212 the longitudinal direction of which is the Y direction, and the measurement pattern 210' including a light-shielding part 212 the longitudinal direction of which is the X direction. The measurement unit 30F has a light-shielding board 320 including the slit-like opening part 322 the longitudinal direction of which is the Y direction and the slit-like opening part 322' the longitudinal direction of which is the X direction. Note that Fig. 14 is a schematic top view showing the measurement mask 20F. Fig. 15 is a schematic top view showing the measurement unit 30F.

Consider a case in which local flare is measured in the X direction using the measurement mask 20F and measurement unit 30F. The position of the opening part 322 of the light-shielding board 320 is aligned with that of a projection image of the light-shielding part 212 of the measurement pattern 210, and local flare is measured while moving the light quantity sensor 340 step by step in the X direction. On the other hand, consider a case in which local flare is measured in the Y direction using the measurement mask 20F and measurement unit 30F. The position of the opening part 322' of the light-shielding board 320 is aligned with that of a projection image of the light-shielding part 212 of the measurement pattern 210', and local flare is measured in the same way.

When the measurement mask 20F and measurement unit 30F are used, it is important to arrange them such that, for example, light is prevented from entering the opening part 322' to measure local flare in the Y direction while local flare is measured in the X direction. This makes it necessary to sufficiently separate the opening part 322' from the position of a projection image of the measurement pattern 210. For this purpose, the opening parts 322 and 322' are preferably formed such that the measurement patterns 210 and 210' become perpendicular to each other (see Fig. 14). However, if the formation region of the measurement pattern 210 or the size of the light quantity sensor 340 has a margin, the opening parts 322 and 3222' can be freely formed as long as they do not come close to each other simultaneously.

Although the measurement mask 20F shown in Fig. 14 has one light-shielding part 212 in each of the X and Y directions, the measurement mask 20F may have a plurality of light-shielding parts 212 in each of the X and Y directions, as described above. A plurality of measurement patterns 210 having light-shielding parts 212 and opening parts 214 with different widths may be formed on the measurement mask 20F.

As described above, the measurement apparatus 1 can accurately measure local flare, which is generated by the optical system TOS to be measured, in a short period of time.

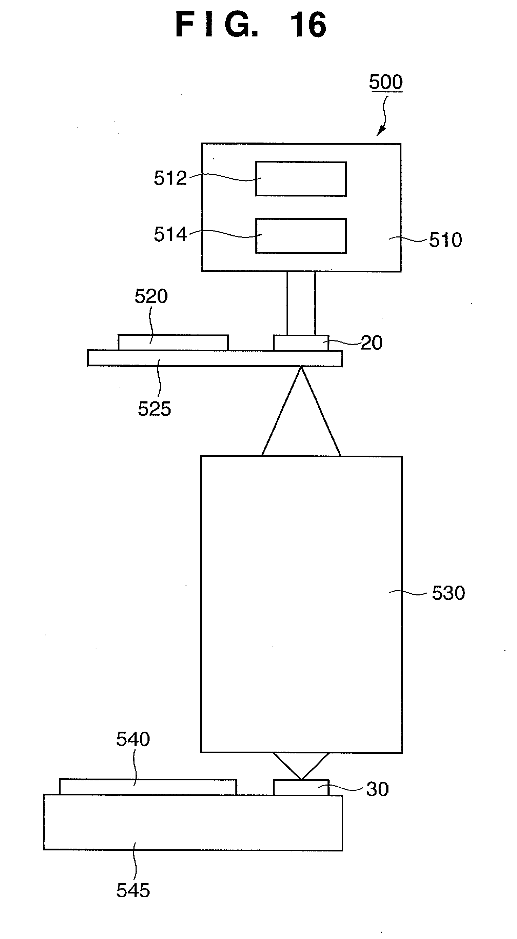

An exposure apparatus to which a measurement apparatus 1 is applied will be explained below. Fig. 16 is a schematic sectional view showing an exposure apparatus 500 according to one aspect of the present invention. In this embodiment, the exposure apparatus 500 is a projection exposure apparatus which transfers the pattern of a reticle 520 onto a wafer 540 using a step & scan scheme. However, the exposure apparatus 500 can also adopt a step & repeat scheme. The exposure apparatus 500 includes an illumination apparatus 510, a reticle stage 525 which supports the reticle 520 and a measurement mask 20, a projection optical system 530, and a wafer stage 545 which supports the wafer 540 and a measurement unit 30. In the exposure apparatus 500, the illumination apparatus 510, measurement mask 20, and measurement unit 30 constitute the above-described measurement apparatus 1.

The illumination apparatus 510 illuminates the measurement mask 20 and the reticle 520 on which a circuit pattern to be transferred is formed, and includes a light source unit 512 and illumination optical system 514.

The light source unit 512 uses, e.g., an excimer laser as a light source. The excimer laser includes, e.g., a KrF excimer laser having a wavelength of about 248 nm and an ArF excimer laser having a wavelength of about 193 nm. However, the light source of the light source unit 512 is not particularly limited to an excimer laser, and may be, e.g., an i-line mercury lamp having a wavelength of about 365 nm.

The illumination optical system 514 illuminates the reticle 520 and measurement mask 20, and includes, e.g., a lens, mirror, optical integrator, phase plate, diffractive optical element, and stop.

The reticle 520 has a circuit pattern, and is supported and driven by the reticle stage 525. Diffracted light generated by the reticle 520 is projected onto the wafer 540 via the projection optical system 530. Since the exposure apparatus 500 is of a step & scan scheme, it transfers the pattern of the reticle 520 onto the wafer 540 by scanning the reticle 520 and wafer 540.

The reticle stage 525 supports the reticle 520 and measurement mask 20, and connects to a moving mechanism (not shown). The moving mechanism (not shown) includes, e.g., a linear motor, and can move the reticle 520 and measurement mask 20 by driving the reticle stage 525 in the X-axis direction.

The projection optical system 530 projects the pattern of the reticle 520 onto the wafer 540. The measurement apparatus 1 including the illumination apparatus 510, measurement mask 20, and measurement unit 30 accurately measure local flare generated by the projection optical system 530, and adjusts it to reduce the local flare based on the measurement result. The pattern (line width) of the reticle 520 may be reversely corrected based on the measurement result obtained by the measurement apparatus 1 so as to form a desired pattern on the wafer 540 upon transfer.

In this embodiment, the wafer 540 is used as the substrate. However, it is also possible to use other substrates such as a glass plate in place of the wafer 540. The wafer 540 is coated with a photoresist.

The wafer stage 545 supports the wafer 540 and measurement unit 30, and drives them using, e.g., a linear motor.

The measurement mask 20 and measurement unit 30 of the measurement apparatus to measure local flare generated by the projection optical system 530 can take any of the above-described forms, and a detailed description thereof (arrangement and measurement operation) will be omitted here. The above-described measurement pattern to measure local flare may be formed on part of the reticle 520.

First, the exposure apparatus 500 measures local flare generated by the projection optical system 530. As described above, local flare generated by the projection optical system 530 is measured using the illumination apparatus 510, measurement mask 20, and measurement unit 30 of the measurement apparatus 1. Next, the exposure apparatus 500 determines the level of the flare in the projection optical system 530 based on the measurement result. Long-term use of the apparatus often changes the flare as a foreign substance adheres on a certain component of an optical system. Even in this case, this measurement allows periodically monitoring a change in flare. If a change in the measurement result of local flare is detected, it is possible to restore it by cleaning an optical system.

The exposure apparatus 500 transfers the pattern of the reticle 520 onto the wafer 540 by exposure. The illumination optical system 514 illuminates the reticle 520 with a light beam emitted by the light source unit 512. The projection optical system 530 images, on the wafer 540, a light component which reflects the pattern of the reticle 520. As described above, the projection optical system 530 used for the exposure apparatus 500 generates a smaller quantity of local flare than the prior arts, and achieves an excellent imaging capability. Hence, the exposure apparatus 500 can provide devices (e.g., a semiconductor device, an LCD device, an image sensing device (e.g., a CCD), and a thin-film magnetic head) with high throughput, high quality, and a good economical efficiency.

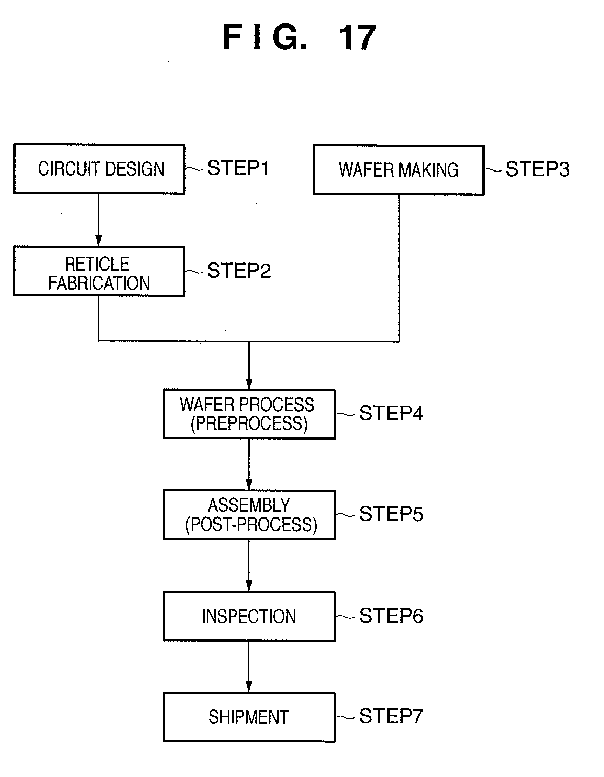

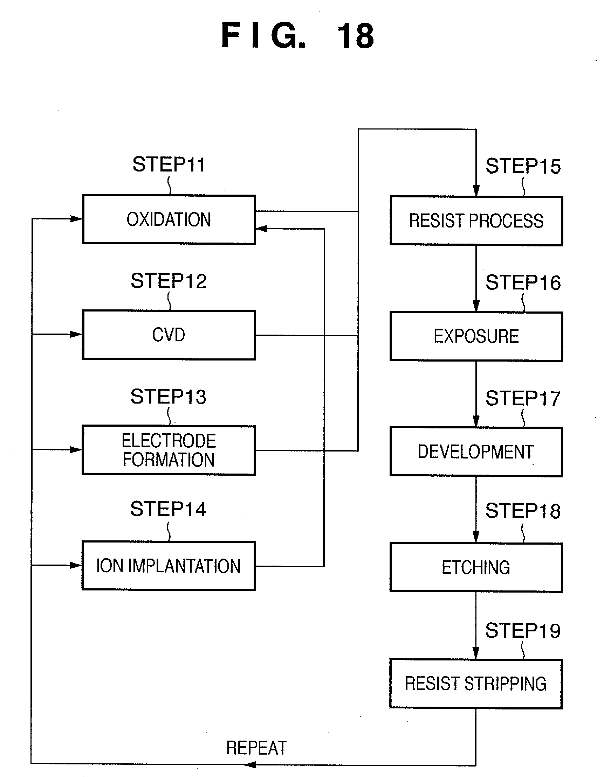

Referring now to Figs. 17 and 18, a description will be given of an embodiment of a device fabrication method using the above mentioned exposure apparatus 500. Fig. 17 is a flowchart for explaining how to fabricate devices (i.e., semiconductor chips such as IC and LSI, LCDs, CCDs, and the like). Here, a description will be given of the fabrication of a semiconductor chip as an example. Step 1 (circuit design) designs a semiconductor device circuit. Step 2 (reticle fabrication) forms a reticle having a designed circuit pattern. Step 3 (wafer making) manufactures a wafer using materials such as silicon. Step 4 (wafer process), which is also referred to as a pretreatment, forms the actual circuitry on the wafer through lithography using the reticle and wafer. Step 5 (assembly), which is also referred to as a posttreatment, forms into a semiconductor chip the wafer formed in Step 4 and includes an assembly step (e.g., dicing, bonding), a packaging step (chip sealing), and the like. Step 6 (inspection) performs various tests on the semiconductor device made in Step 5, such as a validity test and a durability test. Through these steps, a semiconductor device is finished and shipped (Step 7).

Fig. 18 is a detailed flowchart of the wafer process in Step 4. Step 11 (oxidation) oxidizes the wafer's surface. Step 12 (CVD) forms an insulating layer on the wafer's surface. Step 13 (electrode formation) forms electrodes on the wafer by vapor disposition and the like. Step 14 (ion implantation) implants ions into the wafer. Step 15 (resist process) applies a photosensitive material onto the wafer. Step 16 (exposure) uses the exposure apparatus 500 to expose a circuit pattern from the reticle onto the wafer.

Step 17 (development) develops the exposed wafer. Step 18 (etching) etches parts other than a developed resist image. Step 19 (resist stripping) removes unused resist after etching. These steps are repeated to form multi-layer circuit patterns on the wafer. The device fabrication method of this embodiment may manufacture higher quality devices than the conventional one.

Thus, the device fabrication method using the exposure apparatus 500, and resultant devices constitute one aspect of the present invention.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions. The present invention provides a measurement apparatus that includes a measurement unit inserted on an image plane of an optical system to be measured, and a measurement mask inserted on an object plane of the optical system to be measured, said measurement unit including a light-shielding board including a slit-like image-side opening part, and said measurement mask including a rectangular light-shielding part being configured to form a projection image having a longitudinal dimension and lateral dimension longer than a longitudinal dimension and lateral dimension of said image-side opening part on the image plane of the optical system to be measured, and object-side opening parts formed on two sides of said light-shielding part, wherein said measurement apparatus measures flare generated by the optical system to be measured by measuring a light quantity by said light quantity sensor while the projection image covers said image-side opening part.

## Claims

**1.** A measurement apparatus comprising:

a measurement unit inserted on an image plane of an optical system to be measured; and
a measurement mask inserted on an object plane of the optical system to be measured,
said measurement unit including a light-shielding board including a slit-like image-side opening part, and a light quantity sensor being configured to measure a quantity of light passing through said image-side opening part, and said measurement mask including a rectangular light-shielding part being configured to form a projection image having a longitudinal dimension and lateral dimension longer than a longitudinal dimension and lateral dimension of said image-side opening part on the image plane of the optical system to be measured, and object-side opening parts formed on two sides of said light-shielding part,

wherein said measurement apparatus measures flare generated by the optical system to be measured by measuring a light quantity by said light quantity sensor while the projection image covers said image-side opening part.

2. The apparatus according to claim 1, wherein a dimension of said image-side opening part in a second direction perpendicular to a first direction is 10 times or more of a dimension of said image-side opening part in the first direction.

3. The apparatus according to claim 1, wherein said light-shielding board includes a plurality of slit-like image-side opening parts,
said measurement mask includes a plurality of measurement patterns each including a rectangular light-shielding part configured to form a projection image having a longitudinal dimension and lateral dimension longer than a longitudinal dimension and lateral dimension of said image-side opening part on the image plane of the optical system to be measured, and object-side opening parts formed on two sides of said light-shielding part, and
said measurement apparatus measures flare generated by the optical system to be measured by measuring a light quantity by said light quantity sensor while the projection image formed by said light-shielding part of each of said plurality of measurement patterns covers a corresponding one of said plurality of image-side opening parts.

4. The apparatus according to claim 1, wherein said measurement mask includes a plurality of light-shielding parts having different widths.

5. The apparatus according to claim 1, wherein said measurement mask includes a plurality of object-side opening parts having different widths.

6. The apparatus according to claim 1, further comprising a plurality of said measurement mask, in which light-shielding parts of each measurement mask different from each other.

7. An exposure apparatus comprising:

an illumination optical system configured to illuminate a reticle with light from a light source;
a projection optical system configured to project a pattern of the reticle onto a substrate; and
a measurement apparatus according to claim 1,

wherein said measurement apparatus measures flare generated by said projection optical system as an optical system to be measured.

8. A device fabrication method comprising steps of:

exposing a substrate using an exposure apparatus according to claim 7; and
performing a development process for the substrate exposed.

# FIG. 1

<u>1</u>

10

20

TOS

322 — 320
340 } 30

# F I G.  2

# F I G.  3

# F I G.  4

# F I G.  5

1000

# FIG. 6

# F I G. 7

214b  212 322  214a

Y

X

# F I G. 8

# FIG. 9

# F I G. 10

<u>20A</u>

210     210     210

214b 212 214a

Y
X

# F I G.  11

<u>30B</u>

# F I G. 12

20B

214b 214c 212 214c 214c 212 214a

210 210 210 210

EP 1 965 259 A2

FIG. 13A

FIG. 13B

FIG. 13C

23

# F I G. 14

<u>20F</u>

# F I G. 15

30F

322           322'

Y

X        320

# F I G. 16

# F I G.  17

CIRCUIT DESIGN — STEP1

WAFER MAKING — STEP3

RETICLE FABRICATION — STEP2

WAFER PROCESS (PREPROCESS) — STEP4

ASSEMBLY (POST-PROCESS) — STEP5

INSPECTION — STEP6

SHIPMENT — STEP7

# F I G. 18

STEP11

OXIDATION

STEP12

CVD

STEP13

ELECTRODE
FORMATION

STEP14

ION IMPLANTATION

STEP15

RESIST PROCESS

STEP16

EXPOSURE

STEP17

DEVELOPMENT

STEP18

ETCHING

STEP19

RESIST STRIPPING

REPEAT

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004064024 A
- JP 2004296648 A
- JP 2006080245 A

**Non-patent literature cited in the description**

- 0.85NA ArF Exposure System and Performance. *Proc. SPIE,* 2003, vol. 5040, 789-800